# EUROPEAN PATENT SPECIFICATION

(11) **EP 0 611 997 B1**
(45) Date of publication and mention of the grant of the patent: **12.02.2003**
(21) Application number: 93914964.7
(22) Date of filing: 07.07.1993
(51) Int. Cl.: G03F 7/031, C07D 215/14

(54) **PHOTOPOLYMERIZABLE COMPOSITION**
PHOTOPOLYMERISIERBARE ZUSAMMENSETZUNG
COMPOSITION PHOTOPOLYMERISABLE

(30) Priority: 13.07.1992 JP 18522492
(43) Date of publication of application: 24.08.1994
(60) Divisional application: 01106388.0
(73) Proprietor: KYOWA HAKKO KOGYO CO., LTD., Chiyoda-ku, Tokyo 100 (JP)
(72) Inventor: YAMAOKA, Tsuguo, Funabashi-shi, Chiba 273 (JP); KOSEKI, Kenichi, Chiba-shi, Chiba 260 (JP); OBARA, Mitsuharu, Yokohama-shi, Kanagawa 225 (JP); SHIMIZU, Ikuo, Yokkaichi-shi, Mie 512 (JP); ITO, Yukiyoshi, Yokkaichi-shi, Mie 512-0911 (JP); KAWATO, Hitoshi, Yokkaichi-shi, Mie 510-0826 (JP)
(74) Representative: Casalonga, Axel
(86) International application number: JP9300932
(87) International publication number: WO94001806

(56) References cited:
- EP-A- 0 269 397
- EP-A- 0 379 200
- EP-A- 0 408 014
- EP-A- 0 437 259
- EP-A- 0 568 993
- WO-A-93/21236
- JP-A- 2 306 247
- JP-A- 3 126 581
- JP-A- 4 097 153
- JP-A- 4 106 548
- US-A- 5 275 917

## Description

### Technical Field

The present invention relates to photopolymerizable compositions, particularly photopolymerizable compositions having a high sensitivity to visible and near infrared light at a wavelength of 600 nm or more.

### Prior Art

There has been known a photopolymerizable composition comprising an addition-polymerizable compound having at least one ethylenically unsaturated double bond; a squarylium compound represented by the formula: 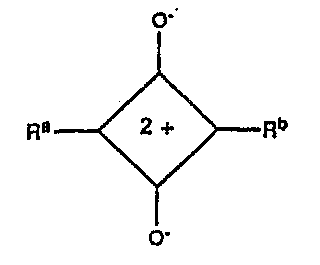 wherein R^{a} and R^{b} each are a substituted or unsubstituted aminophenyl group or a group Y=CH- where Y is a nitrogen-containing heterocyclic group; and an s-triazine compound having at least one halogenated methyl group [Japanese Published Unexamined Patent Application No. 306247/90 (EP379200A)].

Further, a squarylium compound represented by the formula: 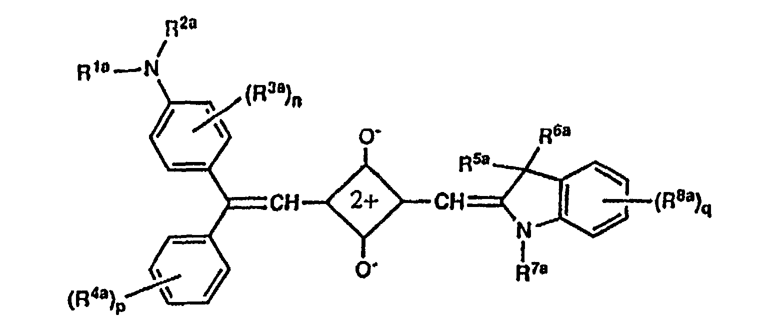 wherein, R^{1a} and R^{2a} may be the same or different, and each represent a hydrogen atom, an alkyl group, a substituted or unsubstituted aryl group or a substituted or unsubstituted aralkyl group; n represents an integer of 0 to 4; R^{3a} may be the same or different, and represents a halogen atom, an alkyl group, an alkoxy group, a nitro group or a hydroxy group; p represents an integer of 0 to 5; R^{4a} may be the same or different, and represents a halogen atom, an alkyl group, an alkoxy group, a hydroxy group, a nitro group, a cyano group, a trifluoromethyl group or a 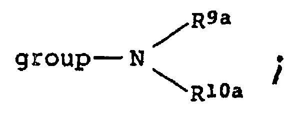 R^{5a} and R^{6a} may be the same or different, and each represent an alkyl group; R^{7a} represents an alkyl group, a substituted or unsubstituted aryl group or a substituted or unsubstituted aralkyl group; q represents an integer of 0 to 4; R^{8a} may be the same or different, and represents a halogen atom, an alkyl group, an alkoxy group, a substituted or unsubstituted aryl or a substituted or unsubstituted aralkyl group or two neighboring R^{8a'}s may be joined together to form an aromatic ring optionally having (a) substituent(s); and R^{9a} and R^{10a} have the same meanings as R^{1a} has been disclosed (Japanese Published Unexamined Patent Application No. 149263/91). There have been filed applications for squarylium compounds represented by the formula: 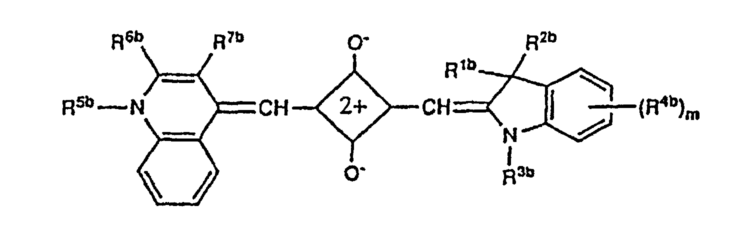 where R^{1b} and R^{2b} may be the same or different and represent an alkyl group, or R^{1b} and R^{2b} may be joined together to form a hydrocarbon ring; R^{3b} represents a hydrogen atom, an alkyl group or an aryl group; m represents an integer of 0 to 4; R^{4b} may be the same or different, and represents a halogen atom, an alkyl group, an aralkyl group, an aryl group or an alkoxy group or two neighboring R^{4b}'s may be joined together to form an aromatic ring optionally having (a) substituent(s); R^{5b} represents an alkyl group; and R^{6b} and R^{7b} may be the same or different, and each represent a hydrogen atom, an alkyl group or an aralkyl group, or R^{6b} and R^{7b} are joined together to form an aromatic ring or a hydrocarbon ring optionally having (a) substituent(s) (Japanese Patent Application No. 106399/92); for squarylium compounds represented by the formula: 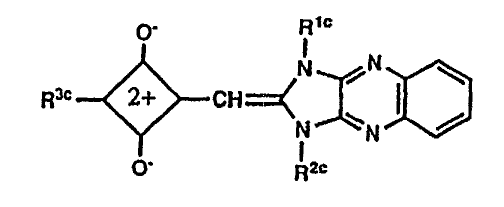 wherein R^{1c} and R^{2c} may be the same or different, and each represent a hydrogen atom, an alkyl group, an aralkyl group or an aryl group; R^{3c} represents a group represented by the formula: 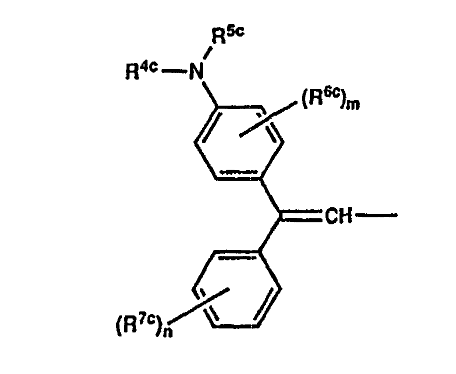 wherein R^{4c} and R^{5c} may be the same or different, and each represent hydrogen, alkyl, substituted or unsubstituted aralkyl or substituted or unsubstituted aryl; m represents an integer of 0 to 4; R^{6c} may be the same or different, and represents a halogen atom, an alkyl group, an alkoxy group, a nitro group or a hydroxy group; n represents an integer of 0 to 5; R^{7c} may be the same or different and represents a halogen atom, an alkyl group, an alkoxy group, a hydroxy group, a nitro group, a cyano group, a trifluoromethyl group or a group: -NQ¹Q² where Q¹ and Q² may be the same or different, and each are defined in the same manner as R^{4c};
or a group represented by the formula: 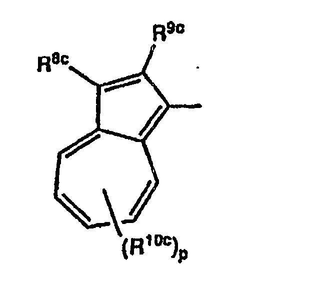 wherein R^{8c} and R^{9c} each represent a hydrogen atom, an alkyl group, an aralkyl group or an aryl group, or R^{8c} and R^{9c} are joined together, to form an aromatic ring, a heterocycylic ring or a hydrocarbon ring optionally having (a) substituent(s); p represents an integer of 0 to 3; R^{10c} may be the same or different and represents an alkyl group, an aralkyl group or an aryl group or two of the neighboring R^{10c}'s are joined together to form an aromatic ring, a heterocyclic ring or a hydrocarbon ring optionally having (a) substituent(s);
or a group represented by the formula: 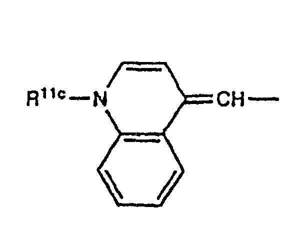 wherein R^{11c} represents an alkyl group (Japanese Patent Application No. 106400/92);
and squarylium compound represented by the formula: 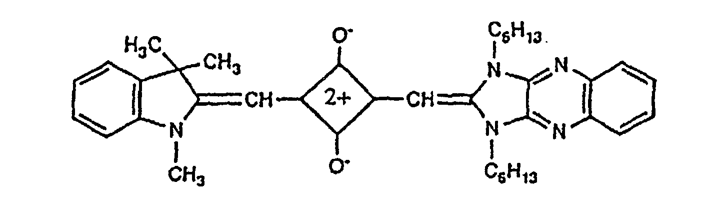 (Japanese Patent Application No. 96173/93)

### Disclosure of the Invention

The present invention relates to photopolymerizable compositions comprising an addition-polymerizable compound which has at least one ethylenically unsaturated double bond, a radical-producing agent and a squarylium compound represented by the formula (I): 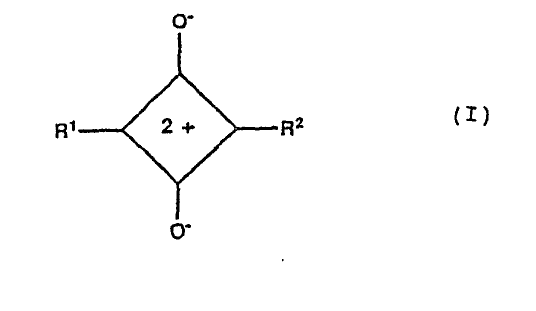 wherein R¹ is a group represented by the formula (II): 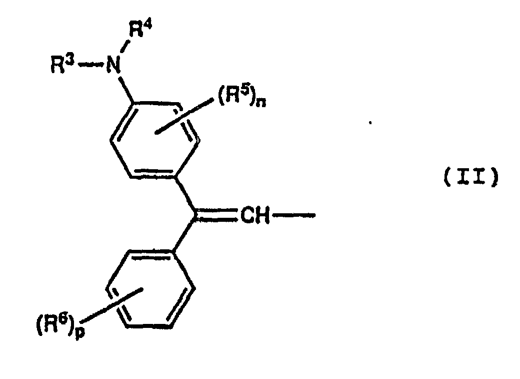 wherein R³ and R⁴ may be the same or different, and each represent a hydrogen atom, an alkyl group, a substituted or unsubstituted aryl group or a substituted or unsubstituted aralkyl group; n represents an integer of 0 to 4; R⁵ may be the same or different, and represents a halogen atom, an alkyl group, an alkoxy group, a nitro group or a hydroxy group; p is an integer of 0 to 5; R⁶ may be the same or different, and represents a halogen atom, an alkyl group, an alkoxy group, a hydroxy group, a nitro group, a cyano group, a trifluoromethyl group, or a group represented by the formula (III): 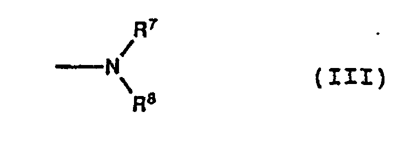 wherein R⁷ and R⁸ may be the same or different, and are defined in the same manner as R³,
or a group represented by the formula (VI): 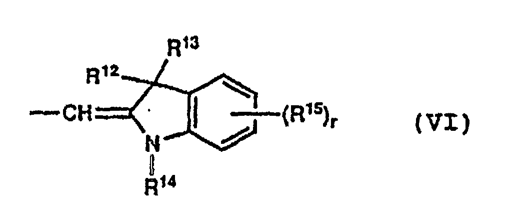 wherein R¹² and R¹³ may be the same or different, and each represent an alkyl group, or R¹² and R¹³ are joined together to form a hydrocarbon ring optionally having (a) substituent(s); R¹⁴ represents a hydrogen atom, an alkyl group, an aralkyl group or an aryl groups r is an integer of 0 to 4; R¹⁵ may be the same or different, and represents a halogen atom, an alkyl group, an aralkyl group, an aryl group or an alkoxy group or two of neighboring R^{15'}s are joined together to form an aromatic ring optionally having (a) substituent(s) selected from a halogen atom, an alkyl group or an alkoxy group and R² is a group represented by the formula (V): 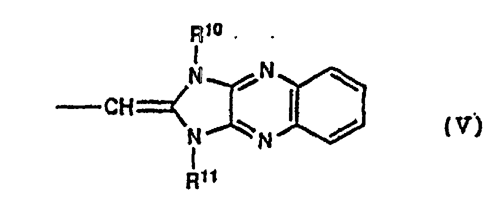 wherein R¹⁰ and R¹¹ may be the same or different, and each represents a hydrogen atom, an alkyl group, an aralkyl group or an aryl group.

In the definitions given above, the alkyl group is exemplified by an alkyl group having from 1 to 6 carbon atoms, e.g., methyl, ethyl, n-propyl, isopropyl, n-butyl, isobutyl, sec-butyl, tert-butyl, n-amyl, isoamyl, sec-amyl, active amyl, tert-amyl, n-hexyl, cyclohexyl, etc.

The aralkyl group includes an aralkyl group having from 7 to 10 carbon atoms, such as benzyl, phenylethyl, phenylpropyl, etc.

The aryl group includes phenyl, naphthyl, etc.

The halogen atom includes chlorine, bromine, fluorine, etc.

The alkyl moiety in the alkoxy group has the same meaning as the alkyl group mentioned above.

The hydrocarbon ring is exemplified by a hydrocarbon ring having from 3 to 7 carbon atoms, including, for example, cyclopropane, cyclobutane, cyclopentane, cyclohexane, cycloheptane, etc.

The substituents for the aryl group, aralkyl group and hydrocarbon ring include halogen, alkyl, alkoxy, etc. Here, the halogen, alkyl and alkoxy have the same meanings as defined above.

The photopolymerizable compositions according to the present invention may be prepared by mixing an addition-polymerizable compound which has at least one ethylenically unsaturated double bond (hereunder referred to as ethylenical compound) with a radical-producing agent, a squarylium compound represented by the formula (I), and, if necessary, a binder polymer, a thermal polymerization inhibitor (e.g., hydroquinone, p-methoxyphenol, etc.), a colorant comprising an organic or inorganic dyeing pigment, a plasticizer, a sensitivity-improving agent (for example, a tert-amine, etc.).

The ethylenical compound is a monomer having an ethylenically unsaturated double bond or a polymer with an ethylenically unsaturated double bond on the main or side chain so that upon irradiation of an active ray to the photopolymerizable composition, the ethylenical compound cures due to addition-polymerization by the action of the radical-producing agent and the photodecomposition product of the squarylium compound, thereby causing insolubility of the ethylenical compound.

The monomer having an ethylenically unsaturated double bond includes, for instance, an unsaturated carboxylic acid, an ester of an unsaturated carboxylic acid and an aliphatic polyhydroxy compound, an ester of an unsaturated carboxylic acid and an aromatic polyhydroxy compound, an ester which is obtained by an esterification reaction of an unsaturated carboxylic acid with a polycarboxylic acid and a polyhydroxy compound.

The unsaturated carboxylic acid is exemplified by acrylic acid, methacrylic acid, itaconic acid, crotonic acid, maleic acid, etc.

The ester of an unsaturated carboxylic acid and an aliphatic polyhydroxy compound includes, for example, acrylic esters, such as ethylene glycol diacrylate, triethylene glycol diacrylate, trimethylol propane triacrylate, trimethylolethane triacrylate, pentaerythritol diacrylate, pentaerythritol triacrylate, pentaerythritol tetraacrylate, dipentaerythritol tetraacrylate, dipentaerythritol pentaacrylate, dipentaerythritol hexaacrylate, glycerol acrylate; methacrylic esters, such as triethylene glycol dimethacrylate, trimethylol propane trimethacrylate, trimethylolethane trimethacrylate, pentaerythritol dimethacrylate, pentaerythritol trimethacrylate, pentaerythritol tetramethacrylate, dipentaerythritol dimethacrylate, dipentaerythritol trimethacrylate, dipentaerythritol tetramethacrylate; as well as itaconic esters, crotonic esters and maleic esters of aliphatic polyhydroxy compounds, etc.

The ester of an unsaturated carboxylic acid and aromatic polyhydroxy compound includes, for example, hydroquinone diacrylate, hydroquinone dimethacrylate, resorcin diacrylate, resorcin dimethacrylate, pyrogallic triacrylate, etc.

The ester which is obtained by an esterification reaction of an unsaturated carboxylic acid with a polycarboxylic acid and a polyhydroxy compound includes, for example, an ester of acrylic acid, phthalic acid and ethylene glycol; an ester of acrylic acid, maleic acid and diethylene glycol; an ester of methacrylic acid, terephthalic acid and pentaerythritol; an ester of acrylic acid, adipic acid, butanediol and glycerin.

The compound available for use according to the present invention which has an ethylenically unsaturated double bond include acrylamides such as ethylene bisacrylamide, allyl esters such as diallyl phthalate, including their prepolymers, vinyl group-containing compound such as divinyl phthalate, etc.

The polymer having an ethylenically unsaturated double bond on the main chain includes, for example, polyesters obtained by a polycondensation reaction of an unsaturated dicarboxylic acid with a dihydroxy compound, a polyamide obtained by a polycondensation reaction of an unsaturated dicarboxylic acid with a diamine.

The polymer having an ethylenically unsaturated double bond on the side chain includes, for example, condensation polymers of a dicarboxylic acid having an unsaturated double bond on the side chain, including, e.g., itaconic acid, propylidenesuccinic acid or ethylidene malonic acid with a dihydroxy or diamine compound, etc. Also, polymers comprising a functional group such as hydroxy group or halomethyl group on the side chain, including, e.g., polymers obtained by a polymeric reaction of a polyvinyl alcohol, poly(2-hydroxyethyl methacrylate), an epoxy resin, a phenoxy resin, polyepichlorohydrin or the like with an unsaturated carboxylic acid such as acrylic acid, methacrylic acid, crotonic acid, etc. are available for use.

The radical-producing agent includes s-triazine compounds having at least one trihalomethyl substituent [2,4,6-tris(trichloromethyl)-s-triazine, 2-(4-methoxyphenyl)-4,6-bis(trichloromethyl)-s-triazine, 2-(4-methoxy-1-naphthalenyl)-4,6-bis(trichloromethyl)-s-triazine, etc.], organic peroxides [3,3',4,4'-tetrakis(t-butyldioxycarbonyl)benzophenone, etc.], N-phenylglycines [N-phenylglycine, p-chloro-N-phenylglycine, m-methyl-N-phenylglycine, etc.], aromatic sulfonyl halide compounds [benzenesulfonyl chloride, p-toluenesulfonyl chloride, etc.], imidazole dimers [2,2'-bis(o-chlorophenyl-4, 4', 5, 5'-tetraphenyl-biimidazole, etc.], metal arene complexes [PF⁻₆ salt of (η⁶-benzene)(η⁵-cyclopentadienyl) iron (II), etc.], titanocene [fluoroaryltitanocene, etc.], diaryl iodonium salts, triaryl sulfonium salts, branched polyethylene imines, etc.

The amount of the radical-producing agent to be used is 1 to 50 parts, preferably 2 to 25 parts, based on 100 parts of the ethylenical compound. The squarylium compound includes the compounds represented by the above formula (I), specifically those listed in Table 1.

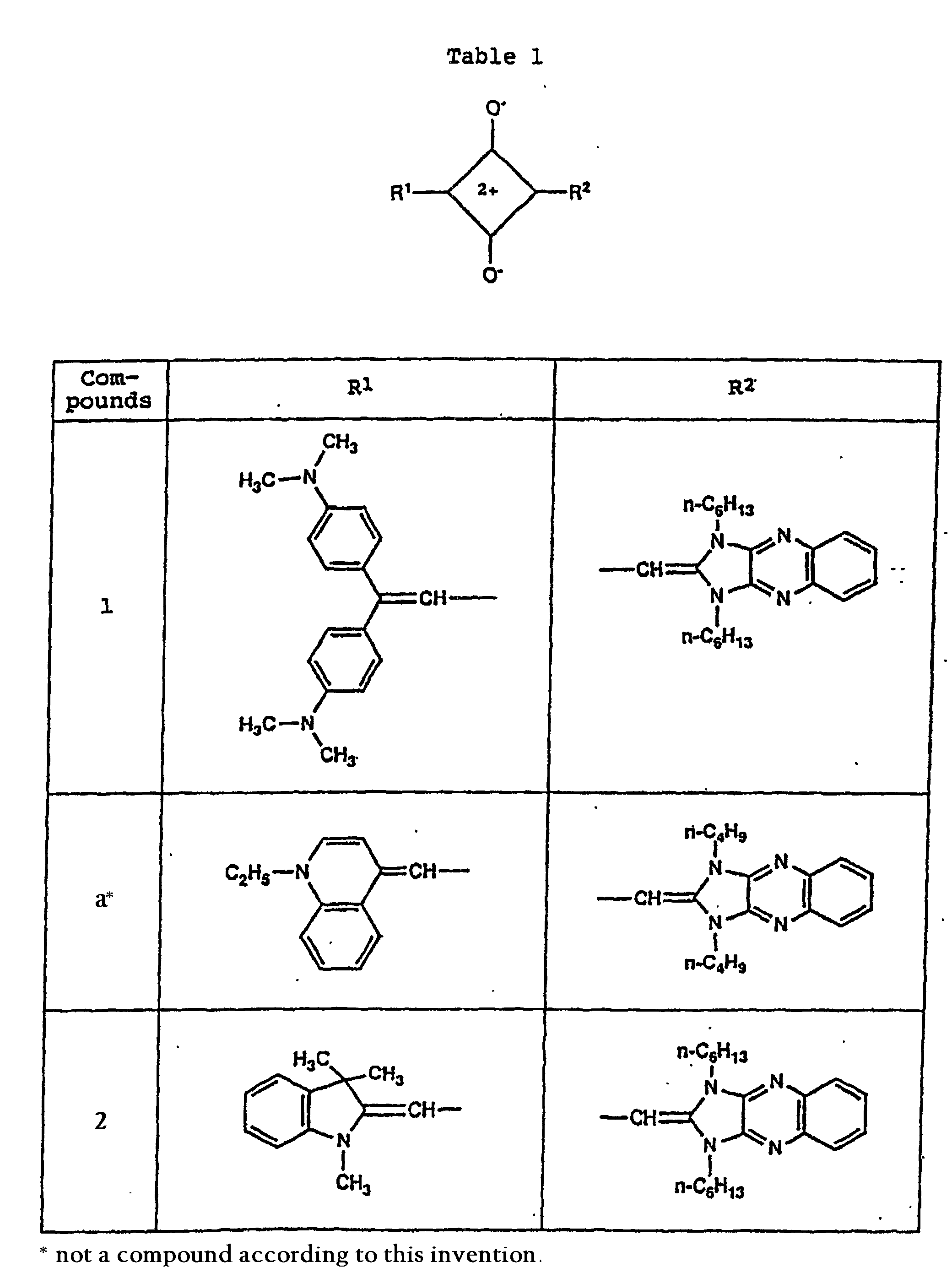

Compounds 1, a, and 2 correspond to the compounds produced in Reference Examples 1, a, and 2, respectively.

Further, the binder polymer includes, for example, polymethacrylic esters or their partial hydrolyzates, polyacrylic esters or their partial hydrolyzates, polystyrene, polyvinyl acetate or its partial hydrolyzates, polyvinyl butyrate, polychloroprene, polyvinyl chloride, chlorinated polyethylene, chlorinated polypropylene, polyvinylpyrrolidone, polyethylene oxide, polymethacrylic acid or methacrylic copolymers with a carboxyl group on the side chain, polyacrylic acid or acrylic copolymers with a carboxyl group on the side chain, polyurethane, polyamide, polycarbonate, acetyl cellulose, polyvinyl carbazole, and other copolymers of acrylic ester, methacrylic ester, maleic acid (anhydride), acrylonitrile, styrene, vinyl acetate, vinyl chloride, vinylidene chloride, butadiene, isoprene, chloroprene, etc.

The amount of the binder polymer to be used is 10 to 1000 parts, preferably 50 to 200 parts, based on 100 parts of the ethylenical compound.

The squarylium compounds represented by the above formula (I) are described in Japanese Published Unexamined Patent Application No. 149263/91, Japanese Patent Application No. 106399/92 and Japanese Patent Application No. 106400/92 and Japanese Patent Application No. 96173/93, and may be obtained by, for example, the following production process: 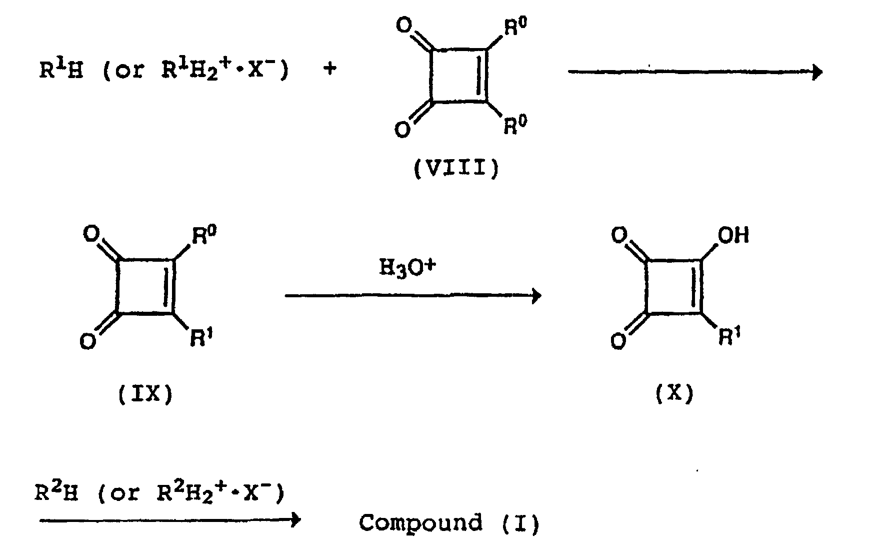 wherein R¹ and R² have the same meanings as defined above, X represents chlorine, bromine, iodine or a group: 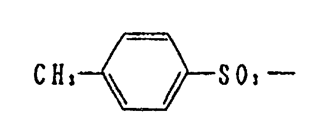 wherein R⁰ represents chlorine or OR¹⁶ where R¹⁶ represents an alkyl of 1 to 4 carbon atoms.

The alkyl having 1 to 4 carbon atoms includes methyl, ethyl, propyl, butyl, etc.

Compound (IX) may be obtained by reacting R¹H or R¹H₂⁺·X⁻ with an equimolar amount of Compound (VIII), and, if necessary, an equimolar amount of a basic compound or metallic sodium in a solvent at 10 to 35°C for from 5 minutes to 5 hours.

The basic compound includes triethylamine, quinoline, pyridine, etc. The solvent includes chloroform, dichloromethane, 1,2-dichloroethane, diethyl ether, diisopropyl ether, tetrahydrofuran, toluene, benzene, dimethylformamide, dimethyl sulfoxide, methanol, ethanol, n-propanol, isopropanol, n-butanol, etc.

Compound (IX) may be isolated by evaporating the solvent from the reaction mixture or by filtering the reaction mixture.

Compound (X) may be produced by heating Compound (IX) in 50 to 90% by weight of an aqueous acetic acid at 90 to 110°C for 1 to 24 hours. Compound (X) may be isolated in the same manner as mentioned above.

Compound (I) may be obtained by reacting Compound (X) with an equimolar amount of Compound R²H or R²H₂⁺·X⁻, and, if necessary, an equimolar to two moles of a basic compound in a solvent at 90 to 110°C for 1 to 40 hours. The basic compound may be chosen in the same manner as mentioned above. The solvent available for use includes an alcoholic solvent having 4 to 6 carbon atoms or a mixed solvent of a 50% or more alcoholic solvent, and one of benzene and toluene.

Compound (I) may be isolated in the same way as mentioned above, and Compound (I) may be further purified by recrystallization, compelled sedimentation, column chromatography, etc.

The photopolymerizable compositions according to the present invention may be applied to various uses including, for example, printing plates as described in Japanese Published Unexamined Patent Application No. 48665/90, microcapsules as described in Japanese Published Unexamined Patent Application No. 306247/90, and holograms as described in Japanese Published Unexamined Patent Application No. 27436/93.

Hereunder an explanation will be provided with regard to the application to printing plates.

The photopolymerizable composition is coated on a base, and the resulting coating layer is provided with a protecting layer thereon to produce a photosensitive sample. The photosensitive sample is subjected to irradiation of light, unexposed portions of the photosensitive sample are removed with a developer to provide a printing plate.

The base includes sheet materials of paper, paper laminated with plastics (polyethylene, polypropylene, etc.), metals such as copper, aluminum, etc., cellulose acetate, polyethylene, polypropylene, etc. Aluminum sheet is most preferred. If aluminum sheet is used as the base, then preferably its surface is treated by graining and anodic oxidation processing.

The protecting layer includes a polymer with excellent oxygen barrier properties, for example, polyvinyl alcohol, cellulose acetate, etc. in order to prevent the polymerization prohibition effect of oxygen in the air.

The irradiation source includes mercury lamp, chemical lamp, carbon arc lamp, xenon lamp, metal halide lamp, various visible, ultraviolet and near infrared lasers, fluorescent lamp, tungsten light, sunlight, etc. The developer includes inorganic alkali chemicals such as sodium silicate, potassium silicate, sodium hydroxide, potassium hydroxide, tribasic sodium phosphate, dibasic sodium phosphate, tribasic ammonium phosphate, dibasic ammonium phosphate, sodium metasilicate, sodium bicarbonate, sodium carbonate, aqueous ammonia, etc., and aqueous solutions of an organic alkali chemical such as monoethanolamine, diethanolamine, etc.

### Modes for Carrying Out the Invention

Examples, comparison examples and reference examples are given below.

### Example 1

In this example, 100 parts of pentaerythritol triacrylate, 100 parts of polymethacrylate polymer (average molecular weight: 150,000), 8 parts of 2,4,6-tris(trichloromethyl)-s-triazine and 1.2 parts of Compound 1 were dissolved in 900 ml of ethylcellosolve to obtain a solution of a photosensitive resin. The solution of a photosensitive resin was coated on an aluminum sheet which had undergone graining and anodic oxidation treatment, to a dry film thickness of 2 µm with a spin coater. Then, the sheet was dried at 80°C for 2 minutes. An aqueous solution of polyvinyl alcohol (Kuraray Poval 706) was coated on the dried sheet to a dried film thickness of 1.0 µm, to provide an overcoat layer. A step tablet with an optical density step of 0.15 was piled on the resulting photosensitive sample. An irradiation was made for two minutes with a light having a wavelength of around 630 nm (66 µJ/cm².S) which passed through a heat ray absorption filter HA-30 (manufactured by Hoya), a colored glass filter R-61 and an interference filter KL-63 (both manufactured by Toshiba Glass Co., Ltd.) from a 3 kW ultrahigh pressure mercury lamp.

The developing was made with PS plate developer DN3C (manufactured by Fuji Photo Film Co., Ltd.), and the sample was inked with PS plate developing ink PI-2 (manufactured by Fuji Photo Film Co., Ltd.) for the determination of the energy level necessary for the curing on the basis of the number of the cured steps. The sensitivity was determined to be 0.56 mJ/cm².

### Example 2

In the same manner as in Example 1, a light having a wavelength of 610 nm or more (2.37 mJ/cm².S) which passed through a heat ray absorption filter HA-30 and a colored glass filter R-61 was used instead of a light having a wavelength of around 630 nm (66 µJ/cm².S) which has passed through a heat ray absorption filter HA-30, a colored glass filter R-61 and an interference filter KL-63. The sensitivity was determined to be 5.9 mJ/cm².

### Example 3

In the same manner as in Example 1, a light having a wavelength of around 780 nm (162 µJ/cm².S) which passed through an interference filter KL-78 (manufactured by Toshiba Glass Co., Ltd.) was used instead of a light having a wavelength of around 630 nm (66 µJ/cm².S) which has passed through a heat ray absorption filter HA-30, a colored glass filter R-61 and an interference filter KL-63. The sensitivity was determined to be 1.2 mJ/cm².

### Example 4 (not an example according to this invention)

In this example, 100 parts of pentaerythritol triacrylate, 100 parts of polymethacrylate polymer (average molecular weight: 150,000), 8 parts of 2,4,6-tris(trichloromethyl)-s-triazine and 1.2 parts of Compound a were dissolved in 900 ml of ethylcellosolve to obtain a solution of a photosensitive resin. The solution of the photosensitive resin was coated on an aluminum sheet which had undergone graining and anodic oxidation treatment, to a dry film thickness of 2 µm with a spin coater. Then, the sheet was dried at 80°C for 2 minutes. An aqueous solution of polyvinyl alcohol (Kuraray Poval 706) was coated on the dried sheet to a dried film thickness of 1.0 µm, to obtain an overcoat layer. A step tablet with an optical density step of 0.15 was piled on the resulting photosensitive sample. An irradiation was made for two minutes with a light having a wavelength of around 780 nm (162 µJ/cm².S) which passed through an interference filter KL-78 from a 3 kW ultrahigh pressure mercury lamp. The developing was made with PS plate developer DN3C, and the sample was inked with PS plate developing ink PI-2 for the determination of the energy level necessary for the curing on the basis of the number of the cured steps. The sensitivity was determined to be 5.6 mJ/cm².

### Comparison Example 1

A photosensitive sample was prepared in the same manner as in Example 4 except that a compound represented by the formula: 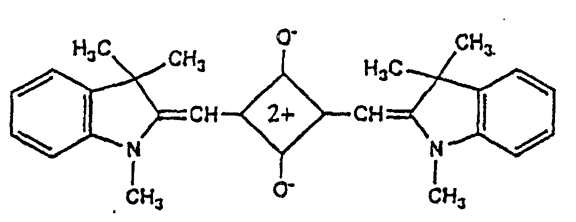 which is described in Japanese Published Unexamined Patent Application No. 306247/90 was used instead of Compound a. The photosensitive sample did not cure.

### Comparison Example 2

A photosensitive sample was prepared in the same manner as in Example 4 except that a compound represented by the formula: 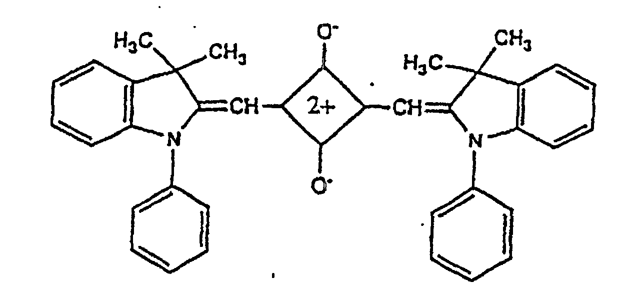 which is described in Japanese Published Unexamined Patent Application No. 306247/90 was used instead of Compound a. The photosensitive sample did not cure.

### Reference Example 1

To 0.3g of 3,4-dichloro-3-cyclobutene-1,2-dione was added 15 ml of dichloromethane. Then, 0.54g of 1,1-bis(p-dimethylaminophenyl)ethylene was added thereto and the mixture was stirred at room temperature for one hour. The dichloromethane was evaporated from the reaction mixture with a rotary evaporator. To the residue were added 7.6 ml of acetic acid and 10 ml of water. The mixture was heated on an oil bath at 100°C. After heating for 1 hour, the acetic acid and water were evaporated with an rotary evaporator. To the residue were added 20 ml of n-butanol, 20 ml of benzene, 1.05g of 1,3-di-n-hexyl-2-methylimidazo[4,5-b]quinoxalinium tosylate and 0.27g of quinoline. The mixture was heated for 2 hours and concentrated with a rotary evaporator. The concentrate was purified by column chromatography to obtain 0.45g of Compound 1.
M. p.: 147°C (dec.)

| Elemental analysis: | C | H | N |
|---|---|---|---|
| Calculated (%) | 75.83 | 7.52 | 12.06 |
| Found (%) | 76.13 | 7.54 | 12.26 |

### Reference Example a

A mixture of 1.98g of 3,4-diisopropoxy-3-cyclobutene-1,2-dione, 2.99g of N-ethyllepidinium iodide and 20 ml of isopropanol was stirred at room temperature. Then, 0.23g of sodium was added thereto and further stirred for 4 hours. Thereafter, the insoluble matters were filtered off, and the filtrate was concentrated. The residue was purified by column chromatography. To the purified product were added 30 ml of acetic acid and 10 ml of water. The mixture was heated at 90 - 100°C for 1.5 hours. After the reaction, the reaction solution was concentrated to dryness. Thereafter, the dried product was heated under reflux for 4 hours together with 13 ml of n-butanol, 0.92g of 1,3-di-n-butyl-2-ethylimidazo[4,5-b]quinoxalinium chloride and 0.27g of quinoline. The solvent and the produced water were evaporated with a rotary evaporator. The resulting residue was purified by column chromatography to obtain 0.31g of Compound a.
M. p.: 237 - 238°C (dec.)

| Elemental analysis: | C | H | N |
|---|---|---|---|
| Calculated (%) | 74.84 | 6.47 | 12.83 |
| Found (%) | 75.13 | 6.52 | 12.94 |

### Reference Example 2

To 1.5g of 3,4-dichloro-3-cyclobutene-1,2-dione was added 20 ml of dichloromethane. Then, 1.7g of 1,3,3-trimethyl-2-methyleneindoline was added dropwise to the mixture with cooling with ice water. After 2 hours, the precipitate was filtered off and dried. To the dried product were added 35 ml of acetic acid and 50 ml of water, followed by heating on an oil bath at 100°C for 1 hour, then the acetic acid and water were evaporated with a rotary evaporator. Then, 100 ml of n-butanol, 5.25g of 1,3-di-n-hexyl-2-methylimidazo[4,5-b]quinoxalimium tosylate and 1.01g of triethylamine were added to the residue, followed by heating under reflux for 3 hours. Then, the reaction mixture was concentrated, and the residue was purified by column chromatography to obtain 3.57g of Compound 2.
M. p.: 173.5 - 174.9°C (dec.)

| Elemental analysis: | C | H | N |
|---|---|---|---|
| Calculated (%) | 75.59 | 7.51 | 11.60 |
| Found (%) | 73.99 | 7.47 | 11.17 |

### Industrial Applicability

The photopolymerizable compositions according to the present invention are suitable for use as materials for PS plates for laser direct process, dry film resists, digital proofs, holograms, photosensitive microcapsules, etc.

## Claims

1. A photopolymerizable composition comprising an addition-polymerizable compound which has at least one ethylenically unsaturated double bond, a radical-producing agent and a squarylium compound represented by the formula (I): 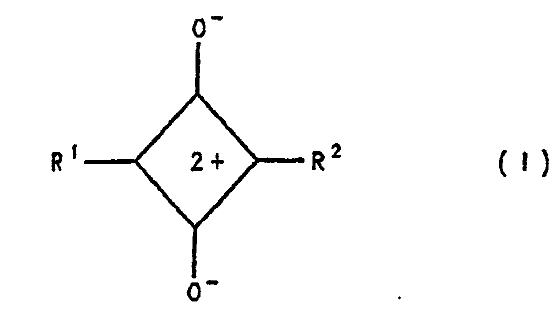 wherein R¹ is a group represented by the formula (II): 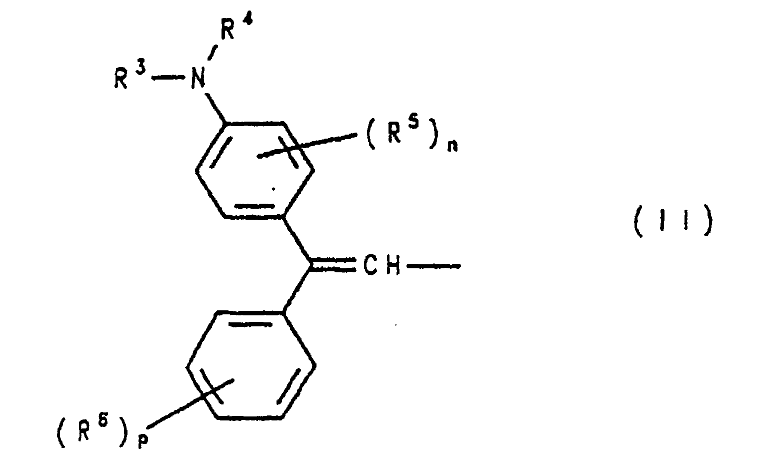 wherein R³ and R⁴ may be the same or different, and each represents a hydrogen atom, an alkyl group, a substituted or unsubstituted aryl or a substituted or unsubstituted aralkyl group; n represents an integer of 0 to 4; R⁵ may be the same or different and represents a halogen atom, an alkyl group, an alkoxy group, a nitro group or a hydroxy group; p is an integer of 0 to 5; R⁶ may be the same or different and represents a halogen atom, an alkyl group, an alkoxy group, a hydroxy group, a nitro group, a cyano group, a trifluoromethyl group or a group represented by the formula (III): 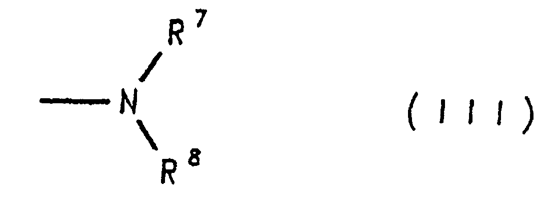 wherein R⁷ and R⁸ may be the same or different, and each are defined in the same manner as R³;
or a group represented by the formula (VI): 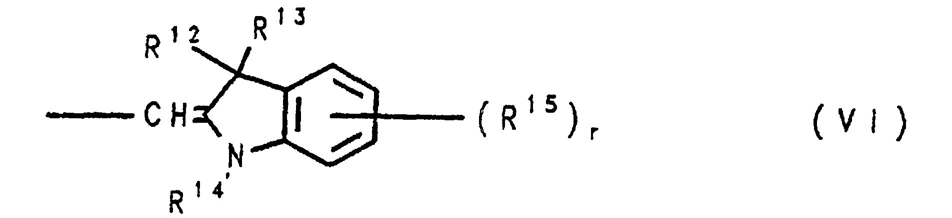 wherein R¹² and R¹³ may be the same or different, and each represents an alkyl group, or R¹² and R¹³, together with the carbon atom to which they are bonded, form a hydrocarbon ring, said hydrocarbon ring being unsubstituted or substituted with at least one of a halogen atom, an alkyl group or an alkoxy group; R¹⁴ represents a hydrogen atom, an alkyl group, an aralkyl group or an aryl group; r is an integer of 0 to 4; R¹⁵ may be the same or different and represents a halogen atom, an alkyl group, an aralkyl group, an aryl group or an alkoxy group, or two adjacent R¹⁵'s may form an aromatic ring being unsubstituted or substituted with at least one of a halogen atom, an alkyl group or an alkoxy group;
and
R² is a group represented by the formula (V): 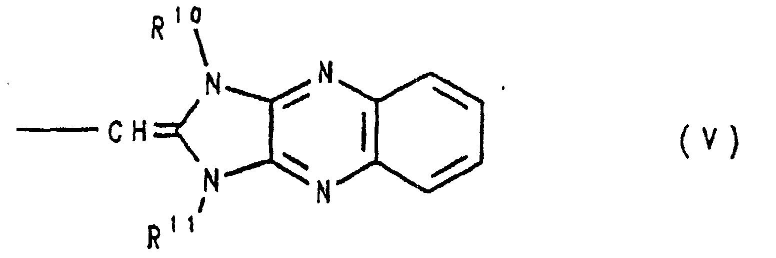 wherein R¹⁰ and R¹¹ may be the same or different, and each represents a hydrogen atom, an alkyl group, an aralkyl group or an aryl group.

## Patentansprüche

1. Photopolymerisierbare Zusammensetzung umfassend eine additionspolymerisierbare Verbindung, die mindestens eine ethylenisch ungesättigte Doppelbindung aufweist, einen Radikalbildner und eine Squaryliumverbindung der Formel (I): 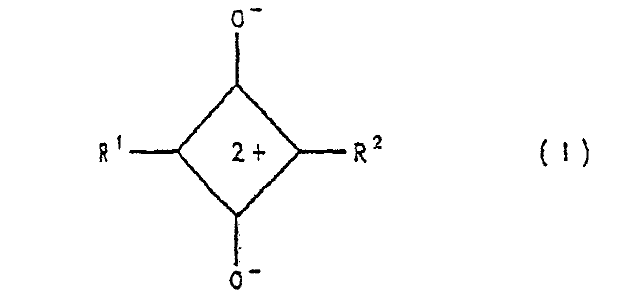 in der R¹ ein Rest der Formel (II) ist: 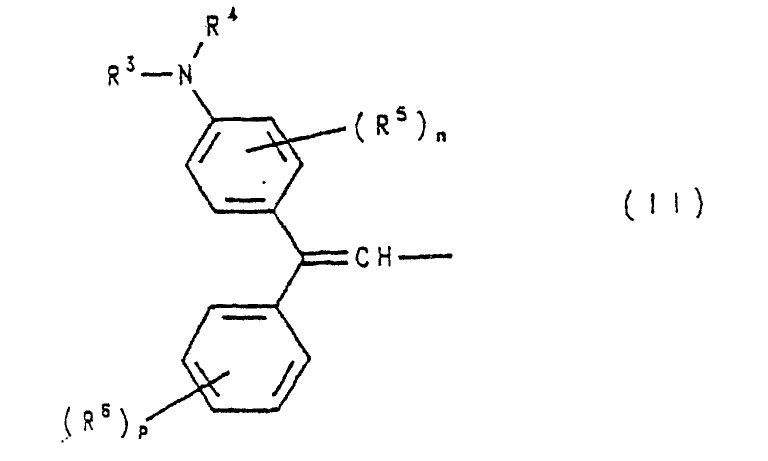 in der R³ und R⁴ gleich oder verschieden sein können und jeweils ein Wasserstoffatom, einen Alkylrest, einen substituierten oder unsubstituierten Aryloder einen substituierten oder unsubstituierten Aralkylrest bedeuten; n eine ganze Zahl von 0 bis 4 bedeutet; R⁵ gleich oder verschieden sein kann und ein Halogenatom, einen Alkylrest, einen Alkoxyrest, eine Nitrogruppe oder eine Hydroxygruppe bedeutet; p eine ganze Zahl von 0 bis 5 ist; R⁶ gleich oder verschieden sein kann und ein Halogenatom, einen Alkylrest, einen Alkoxyrest, eine Hydroxygruppe, eine Nitrogruppe, eine Cyanogruppe, eine Trifluormethylgruppe oder einen Rest der Formel (III): 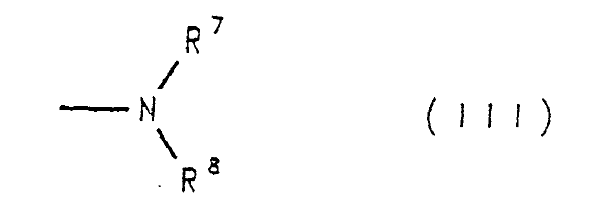 in der R⁷ und R⁸ gleich oder verschieden sein können und jeweils in gleicher Weise wie R³ definiert sind;
oder einen Rest der Formel (VI) bedeutet: 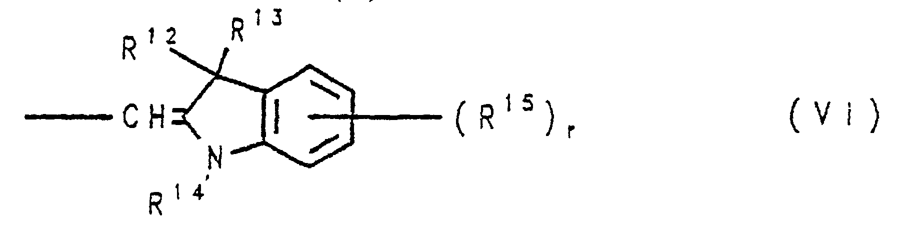 in der R¹² und R¹³ gleich oder verschieden sein können und jeweils einen Alkylrest bedeuten, oder R¹² und R¹³, zusammen mit dem Kohlenstoffatom, an das sie gebunden sind, einen Kohlenwasserstoffring bilden, wobei der Kohlenwasserstoffring unsubstituiert oder mit mindestens einem aus einem Halogenatom, einem Alkylrest oder einem Alkoxyrest substituiert ist; R¹⁴ ein Wasserstoffatom, einen Alkylrest, einen Aralkylrest oder einen Arylrest bedeutet; r eine ganze Zahl von 0 bis 4 ist; R¹⁵ gleich oder verschieden sein kann und ein Halogenatom, einen Alkylrest, einen Aralkylrest, einen Arylrest oder einen Alkoxyrest bedeutet, oder zwei benachbarte R¹⁵ einen aromatischen Ring bilden können, der unsubstituiert oder mit mindestens einem aus einem Halogenatom, einem Alkylrest oder einem Alkoxyrest substituiert ist; und
R² ein Rest der Formel (V) ist: 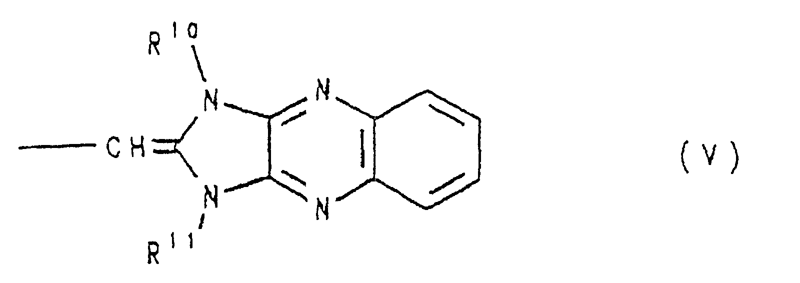 in der R¹⁰ und R¹¹ gleich oder verschieden sein können und jeweils ein Wasserstoffatom, einen Alkylrest, einen Aralkylrest oder einen Arylrest bedeuten.

## Revendications

1. Composition photopolymérisable qui contient un composé polymérisable par addition et comportant au moins une double liaison ou insaturation éthylénique, un agent produisant des radicaux, et un composé de type squarylium, représenté par la formule (I) : 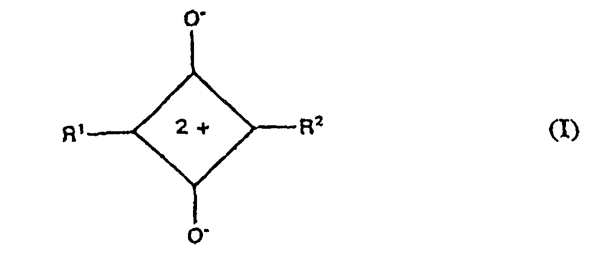 dans laquelle R¹ représente soit un groupe de formule (II) : 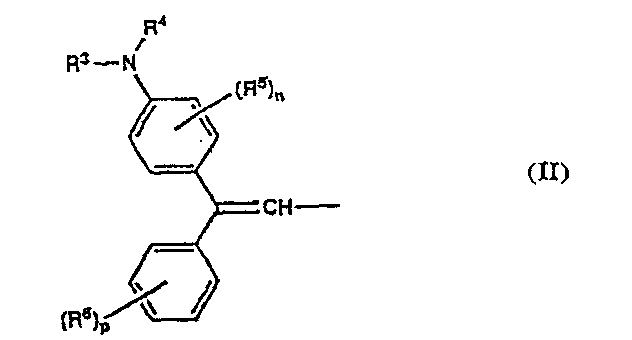 dans laquelle
- R³ et R⁴, qui peuvent être identiques ou différents, représentent chacun un atome d'hydrogène ou un groupe alkyle, aryle substitué ou non, ou aralkyle substitué ou non,
- n représente un nombre entier valant de 0 à 4,
- les R⁵, qui peuvent être identiques ou différents, représentent chacun un atome d'halogène ou un groupe alkyle, alcoxy, nitro ou hydroxy,
- p représente un nombre entier valant de 0 à 5,
- les R⁶, qui peuvent être identiques ou différents, représentent chacun un atome d'halogène ou un groupe alkyle, alcoxy, hydroxy, nitro, cyano ou trifluorométhyle, ou encore un groupe de formule (III) 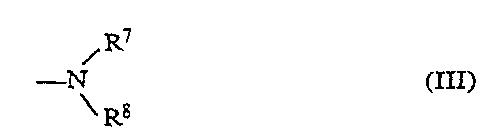
dans laquelle R⁷ et R⁸, qui peuvent être identiques ou différents, ont la même signification que R³,
soit un groupe de formule (VI) : 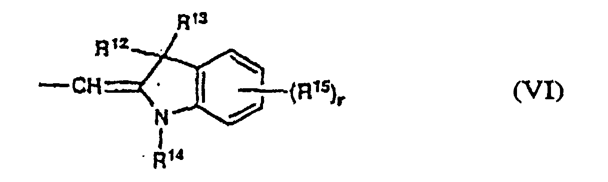 dans laquelle
- R¹² et R¹³, qui peuvent être identiques ou différents, représentent chacun un groupe alkyle, ou bien R¹² et R¹³ forment ensemble, avec l'atome de carbone auquel ils sont liés, un cycle hydrocarboné qui ne porte aucun substituant ou porte au moins un substituant choisi parmi les atomes d'halogène et les groupes alkyle et alcoxy,
- R¹⁴ représente un atome d'hydrogène ou un groupe alkyle, aralkyle ou aryle,
- r représente un nombre entier valant de 0 à 4,
- et les R¹⁵, qui peuvent être identiques ou différents, représentent chacun un atome d'halogène ou un groupe alkyle, aralkyle, aryle ou alcoxy, ou encore deux R¹⁵ adjacents peuvent former un cycle aromatique qui ne porte aucun substituant ou porte au moins un substituant choisi parmi les atomes d'halogène et les groupes alkyle et alcoxy ;
et R² représente un groupe de formule (V) : 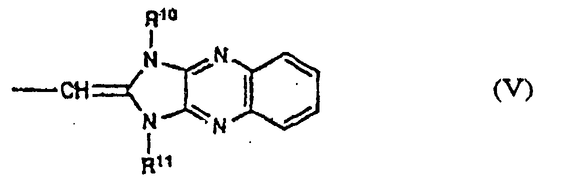 dans laquelle
- R¹⁰ et R¹¹, qui peuvent être identiques ou différents, représentent chacun un atome d'hydrogène ou un groupe alkyle, aralkyle ou aryle.
